# EUROPÄISCHE PATENTSCHRIFT

(11) **EP 3 240 049 B1**
(45) Veröffentlichungstag und Bekanntmachung des Hinweises auf die Patenterteilung: **12.04.2023**
(21) Anmeldenummer: 17174233.1
(22) Anmeldetag: 23.12.2010
(51) Int. Cl.: H01L 33/24, H01L 33/02, H01L 27/15

(54) **VERFAHREN ZUR HERSTELLUNG EINES OPTOELEKTRONISCHEN HALBLEITERCHIPS UND OPTOELEKTRONISCHER HALBLEITERCHIP**
METHOD FOR MANUFACTURING AN OPTOELECTRONIC SEMICONDUCTOR CHIP AND OPTOELECTRONIC SEMICONDUCTOR CHIP
PROCÉDÉ DE FABRICATION D'UNE PUCE À SEMI-CONDUCTEUR OPTOÉLECTRONIQUE ET PUCE À SEMI-CONDUCTEUR OPTOÉLECTRONIQUE

(30) Priorität: 30.12.2009 DE 102009060750
(43) Veröffentlichungstag der Anmeldung: 01.11.2017
(62) Teilanmeldung aus: 10796415.7
(73) Patentinhaber: OSRAM Opto Semiconductors GmbH, 93055 Regensburg (DE)
(72) Erfinder: Butendeich, Rainer, 93059 Regensburg (DE); Walter, Alexander, 93164 Laaber (DE); Peter, Matthias, 93055 Regensburg (DE); Meyer, Tobias, 93051 Regensburg (DE); Taki, Tetsuya, 216-0006 Kanagawa (JP); Maiwald, Hubert, 93073 Neutraubling (DE)
(74) Vertreter: Epping - Hermann - Fischer

(56) Entgegenhaltungen:
- WO-A1-2006/118623
- US-A1- 2009 014 713
- CHI-LING LEE; WEI-I LEE: "Using planarized p-GaN layer to reduce electrostatic discharged damage in nitride-based light-emitting diode", JAPANESE JOURNAL OF APPLIED PHYSICS, Bd. 46, Nr. 19, 11. Mai 2007 (2007-05-11), Seiten L457-L460, XP002621738, Japan DOI: 10.1143/jjap.46.l457
- TAKAHASHI H ET AL: "EFFECT OF INTENTIONALLY FORMED 'V-DEFECTS' ON THE EMISSION EFFICIENCY OF GALNN SINGLE QUANTUM WELL", JAPANESE JOURNAL OF APPLIED PHYSICS, JAPAN SOCIETY OF APPLIED PHYSICS, JP, Bd. 39, Nr. 6B, PART 02, 15. Juni 2000 (2000-06-15), Seiten L569-L571, XP001206768, ISSN: 0021-4922, DOI: DOI:10.1143/JJAP.39.L569
- HANGLEITER A ET AL: "Suppression of nonradiative recombination by V-shaped pits in GaInN/GaN quantum wells produces a large increase in the light emission efficiency", PHYSICAL REVIEW LETTERS, AMERICAN PHYSICAL SOCIETY, NEW YORK, US, Bd. 95, Nr. 12, 16. September 2005 (2005-09-16), Seiten 127402/1-4, XP002389331, ISSN: 0031-9007, DOI: DOI:10.1103/PHYSREVLETT.95.127402
- PARK EUN-HYUN ET AL: "InGaN-light emitting diode with high density truncated hexagonal pyramid shaped p-GaN hillocks on the emission surface", APPLIED PHYSICS LETTERS, AIP, AMERICAN INSTITUTE OF PHYSICS, MELVILLE, NY, US, Bd. 89, Nr. 25, 19. Dezember 2006 (2006-12-19), Seiten 251106-251106, XP012087701, ISSN: 0003-6951, DOI: DOI:10.1063/1.2410229

## Beschreibung

Es werden ein Verfahren zur Herstellung eines optoelektronischen Halbleiterchips und ein optoelektronischer Halbleiterchip angegeben.

Halbleiterchips mit V-Pits sind in der Patentanmeldung US 2009/0014713 A1 und in der Publikation "Using planarized p-GaN layer to reduce electrostatic discharge damage in nitride-based light-emitting diode" von Ching-Ling Lee und Wie-I Lee, Japanese Journal of Applied Physics, Bd. 46, Nr. 19, 11. Mai 2007, Seiten L457-L460 angegeben.

In der Patentanmeldung WO 2006/118623 A1 ist ein Verfahren zur Herstellung von Halbleiterchips angegeben.

Eine zu lösende Aufgabe besteht darin, einen optoelektronischen Halbleiterchip anzugeben, der besonders stabil gegen elektrostatische Entladungen, so genannte ESD-Spannungspulse, ist. Es ist weiter Aufgabe, ein Verfahren zur Herstellung eines solchen optoelektronischen Halbleiterchips anzugeben.

Bei dem optoelektronischen Halbleiterchip handelt es sich um einen strahlungsempfangenden oder strahlungsaussendenden optoelektronischen Halbleiterchip. Beispielsweise handelt es sich bei dem optoelektronischen Halbleiterchip um einen Leuchtdiodenchip, der im Betrieb grünes und/oder blaues Licht emittiert.

Der optoelektronische Halbleiterchip weist eine erste Halbleiterschichtenfolge auf, die eine Vielzahl von Mikrodioden umfasst. Unter einer Halbleiterschichtenfolge ist dabei eine Abfolge von Halbleiterschichten zu verstehen. Im Extremfall kann die Halbleiterschichtenfolge eine einzige Halbleiterschicht umfassen. Eine Halbleiterschicht ist insbesondere dadurch gekennzeichnet, dass sich die Materialzusammensetzung innerhalb der Schicht nicht oder kaum ändert und/oder dass der Bereich, den die Schicht bildet, eine bestimmte Funktion im Halbleiterchip wahrnimmt. Eine Halbleiterschicht kann dabei eine Vielzahl von Monolagen eines Halbleitermaterials umfassen.

Bei den Mikrodioden handelt es sich um pn-Übergänge in der Halbleiterschichtenfolge, welche eine für eine Halbleiterdiode typische Strom-Spannungskennlinie aufweisen. Im Betrieb des optoelektronischen Halbleiterchips findet im Bereich der Mikrodioden vorzugsweise keine strahlende Rekombination von Ladungsträgern statt. Das heißt, die Mikrodioden sind nicht zur Erzeugung von elektromagnetischer Strahlung, zumindest nicht zur Erzeugung von elektromagnetischer Strahlung im sichtbaren Bereich, vorgesehen.

Die Mikrodioden weisen in ihrer Sperrrichtung eine Durchbruchspannung auf. Die Mikrodioden sind dabei vorzugsweise derart ausgebildet, dass sie beim Überschreiten der Durchbruchspannung - zumindest in einem bestimmten Bereich der Stromstärke des durch die Mikrodioden fließenden Stroms - nicht zerstört werden.

Die Mikrodioden weisen ferner in Durchlassrichtung eine Einsatzspannung auf, ab der ein Strom durch die Mikrodioden fließen kann.

Dass die erste Halbleiterschichtenfolge die Mikrodioden umfasst, heißt dabei, dass zumindest ein Teil der Mikrodioden in der ersten Halbleiterschichtenfolge angeordnet ist. Zum Beispiel kann jeweils die n-Seite oder die p-Seite der Mikrodioden in der ersten Halbleiterschichtenfolge angeordnet sein. Der verbleibende Teil der Mikrodioden kann dann in einer anderen Schicht oder Schichtenfolge angeordnet sein.

Der optoelektronische Halbleiterchip umfasst eine zweite Halbleiterschichtenfolge, die einen aktiven Bereich umfasst. Der aktive Bereich ist dabei im Betrieb des optoelektronischen Halbleiterchips zur Erzeugung oder zur Detektion von elektromagnetischer Strahlung vorgesehen. Das heißt, im aktiven Bereich findet beispielsweise eine strahlende Rekombination von Ladungsträgern statt, bei der sichtbares Licht erzeugt werden kann. Der aktive Bereich umfasst dazu beispielsweise wenigstens eine Mehrfachquantentopfstruktur.

Die Bezeichnung Quantentopfstruktur entfaltet hierbei keine Bedeutung hinsichtlich der Dimensionalität der Quantisierung. Sie umfasst somit u.a. Quantentröge, Quantendrähte und Quantenpunkte und jede Kombination dieser Strukturen. Beispiele für Mehrfachquantentopfstruktur-Strukturen sind in den Druckschriften WO 01/39282, US 5,831,277, US 6,172,382 B1 und US 5,684,309 beschrieben, deren Offenbarungsgehalt insofern hiermit durch Rückbezug aufgenommen wird.

Der aktive Bereich ist dabei in der zweiten Halbleiterschichtenfolge angeordnet, wenn zumindest ein Teil des aktiven Bereichs, zum Beispiel die n-Seite oder die p-Seite in der zweiten Halbleiterschichtenfolge angeordnet ist. Zum Beispiel ist die Mehrfachquantentopfstruktur vollständig in der zweiten Halbleiterschichtenfolge angeordnet

Die erste Halbleiterschichtenfolge und die zweite Halbleiterschichtenfolge basieren auf einem Nitrid-Verbindungshalbleitermaterial.

Auf Nitrid-Verbindungshalbleitermaterial basierend bedeutet im vorliegenden Zusammenhang, dass die Halbleiterschichtenfolgen oder zumindest ein Teil davon, ein Nitrid-Verbindungshalbleitermaterial, vorzugsweise AlₙGaₘIn₁₋ₙ₋ₘN aufweist oder aus diesem besteht, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt und/oder ergänzt sein können.

Beispielsweise basieren die erste Halbleiterschichtenfolge und die zweite Halbleiterschichtenfolge auf einem InGaN- und/oder einem GaN-Halbleitermaterial.

Die erste Halbleiterschichtenfolge ist der zweiten Halbleiterschichtenfolge in einer Wachstumsrichtung der Halbleiterschichtenfolge vorgelagert. Das heißt, bei der Herstellung des optoelektronischen Halbleiterchips wird zunächst die erste Halbleiterschichtenfolge und nachfolgend die zweite Halbleiterschichtenfolge aufgewachsen. Die zweite Halbleiterschichtenfolge kann dabei direkt auf der ersten Halbleiterschichtenfolge angeordnet sein. Dies erweist sich besonders bei Halbleiterchips als vorteilhaft, die grünes Licht emittierende Leuchtdioden bilden. Insbesondere bei blaues Licht emittierenden Leuchtdioden ist es möglich, dass eine Zwischenschicht zwischen der ersten und der zweiten Halbleiterschichtenfolge angeordnet ist.

Die Mikrodioden bilden einen ESD-Schutz für den aktiven Bereich des optoelektronischen Halbleiterchips. Das heißt, im Falle eines ESD-Spannungspulses sind die Mikrodioden dazu eingerichtet, einen elektrischen Strom abzuführen. Die durch den ESD-Spannungspuls eingeprägte Ladung fließt also über zumindest einen Teil der Mikrodioden ab und nicht oder kaum über den aktiven Bereich, sodass keine Schädigung des aktiven Bereichs erfolgt. Der optoelektronische Halbleiterchip weist dadurch eine ESD-Festigkeit von wenigstens 1 kV auf. Beispielsweise wird eine ESD-Festigkeit von wenigstens 1 kV, typisch von etwa 2 kV erreicht.

Gemäß zumindest einer Ausführungsform des optoelektronischen Halbleiterchips weist ein Großteil der Mikrodioden gleichartige elektrische Eigenschaften auf. Das heißt, wenigstens 50 % der Mikrodioden, insbesondere wenigstens 75 %, im Extremfall 90 % und mehr der Mikrodioden weisen gleichartige elektrische Eigenschaften auf. Erfindungsgemäß handelt es sich bei einer elektrischen Eigenschaft, welche die Mikrodioden charakterisiert, um das Durchbruchsverhalten der Mikrodioden. Die Mikrodioden weisen, gemäß der beanspruchten Erfindung, ein gleichartiges Durchbruchverhalten auf. Das heißt, die Durchbruchspannung in Sperrrichtung der Mikrodioden ist bei einem Großteil der Mikrodioden im Wesentlichen gleich. Erfindungsgemäß ist die Durchbruchspannung der Mikrodioden von wenigstens 50 %, insbesondere wenigstens 75 %, im Extremfall von 90 % und mehr in einem Bereich von ±25 %, insbesondere von ±10 % um einen Mittelwert der Durchbruchspannung der Mikrodioden. Auf diese Weise ist es möglich, dass bei einem ESD-Spannungspuls in Sperrrichtung ein Großteil der Mikrodioden gleichzeitig öffnet. Der ESD-Spannungspuls fließt dann nicht nur über wenige Leckpfade ab, sondern verteilt sich auf das Ensemble der Mikrodioden und damit im Idealfall über die gesamte Querschnittsfläche des optoelektronischen Halbleiterchips. Auf diese Weise ist eine besonders hohe ESD-Festigkeit des optoelektronischen Halbleiterchips erreicht.

Mit anderen Worten erhöhen die Mikrodioden nicht den elektrischen Widerstand entlang eines möglichen Durchbruchpfades im optoelektronischen Halbleiterchip, sondern durch eine Vielzahl gleichartiger Mikrodioden kann ein ESD-Spannungspuls großflächig abgeführt werden, so dass durch jede Mikrodiode nur wenig Strom fließt, der nicht zu einer lokalen Zerstörung des optoelektronischen Halbleiterchips führt.

Erfindungsgemäß weist der optoelektronische Halbleiterchip eine erste Halbleiterschichtenfolge auf, die eine Vielzahl von Mikrodioden umfasst. Weiter weist der optoelektronische Halbleiterchip eine zweite Halbleiterschichtenfolge auf, die einen aktiven Bereich umfasst. Die erste und die zweite Halbleiterschichtenfolge sind dabei in Wachstumsrichtung aufeinander angeordnet und basieren jeweils auf einem Nitrid-Verbindungshalbleitermaterial. Die Mikrodioden bilden dabei einen ESD-Schutz für den aktiven Bereich und erhöhen somit die ESD-Festigkeit des optoelektronischen Halbleiterchips.

Gemäß zumindest einer Ausführungsform des optoelektronischen Halbleiterchips ist zumindest eine der Mikrodioden durch einen V-Defekt (englisch: V-Pit) gebildet. Beispielsweise sind alle Mikrodioden des optoelektronischen Halbleiterchips jeweils durch einen V-Defekt gebildet. Ein V-Defekt hat im Nitrid-Verbindungshalbleitermaterial beispielsweise die Form einer offenen, in Wachstumsrichtung invertierten Pyramide, die beispielsweise eine hexagonale Grundfläche aufweist. Im Querschnitt hat dieser Defekt die Form eines Vs. Ein V-Defekt kann im Nitrid-Verbindungshalbleitermaterial - beispielsweise in einer Schicht, die auf GaN basiert oder aus diesem Halbleitermaterial besteht - durch Einstellen der Wachstumsparameter, insbesondere der Wachstumstemperatur, erzeugt werden. Die Größe des V-Defekts hängt dann von der Dicke der Schicht ab, in der er erzeugt ist. V-Defekte bilden sich beispielsweise im Bereich von Fadenversetzungen (englisch: threading dislocations), die zum Beispiel bei der Heteroepitaxie des Halbleitermaterials auf ein Wachstumssubstrat entstehen, das eine andere Gitterkonstante als das Halbleitermaterial aufweist. Beispielsweise wird das Nitrid-Verbindungshalbleitermaterial vorliegend auf ein Wachstumssubstrat aus Saphir aufgewachsen, zu dem das Nitrid-Verbindungshalbleitermaterial eine Gitterfehlanpassung von zirka 14 % aufweist. Fadenversetzung werden jedoch auch bei der Homoepitaxie beobachtet, so dass die Halbleiterschichtenfolgen zum Beispiel auch auf ein Wachstumssubstrat abgeschieden werden könne, dass auf GaN basiert oder aus GaN besteht.

Insbesondere ist es möglich, dass ein Großteil der V-Defekte ähnliche Abmessungen aufweist. Das heißt, wenigstens 50 %, insbesondere wenigstens 75 % oder im Extremfall 90 % und mehr der V-Defekte weisen ähnliche Abmessungen auf. V-Defekte weisen dabei ähnliche Abmessungen auf, wenn beispielsweise die Grundfläche der V-Defekte in einer Ebene senkrecht zur Wachstumsrichtung höchstens um ±25 %, insbesondere höchstens um ±10 % um einen Mittelwert der Grundfläche der V-Defekte in dieser Ebene schwankt. Das heißt, ein Großteil der V-Defekte zeichnet sich dann durch eine gleiche oder ähnliche Grundfläche auf. V-Defekte mit ähnlichen Abmessungen bilden Mikrodioden, die gleichartige elektrische Eigenschaften aufweisen. Das heißt, durch V-Defekte mit ähnlichen Abmessungen sind Mikrodioden mit gleichartigen elektrischen Eigenschaften, insbesondere mit einem gleichartigen Durchbruchsverhalten gebildet.

Die V-Defekte sind zum Beispiel vollständig in der ersten Halbleiterschichtenfolge angeordnet.

Gemäß zumindest einer Ausführungsform des optoelektronischen Halbleiterchips umfasst zumindest eine der Mikrodioden einen pn-Übergang. Die Mikrodioden umfassen jeweils einen pn-Übergang. Ferner umfasst auch der aktive Bereich zumindest einen pn-Übergang. Der aktive Bereich umfasst einen pn-Übergang. Das heißt, sowohl die Mikrodioden als auch der aktive Bereich können als Halbleiterdioden mit einer für Halbleiterdioden typischen Strom-Spannungskennlinie beschrieben werden. Erfindungsgemäß sind der pn-Übergang der Mikrodiode und der pn-Übergang des aktiven Bereichs gleichgerichtet. Gemäß zumindest einer Ausführungsform des optoelektronischen Halbleiterchips weist der pn-Übergang der Mikrodiode eine niedrigere Durchbruchspannung in Sperrrichtung auf als der pn-Übergang des aktiven Bereichs. Dabei ist das Durchbruchsverhalten der Mikrodioden vorzugsweise gleichartig ausgebildet.

Dies kann dadurch erreicht sein, dass die Mikrodioden jeweils durch einen V-Defekt gebildet sind.

Bei einem ESD-Spannungspuls in Sperrrichtung öffnen dann vorzugsweise einige, zum Beispiel wenigsten 50%, insbesondere wenigstens 75%, im Extremfall wenigstens 90% oder alle Mikrodioden gleichzeitig. Damit fließt die durch den ESD-Spannungspuls eingeprägte Ladung nicht ausschließlich über einen oder wenige Leckpfade mit geringer Durchbruchspannung, sondern verteilt sich auf das Ensemble der durch die Mikrodioden vorgegebenen Leckpfade. Damit wird in keinem der Strompfade, durch die die Ladung abfließt, eine kritische Stromdichte erreicht, die zur Zerstörung des optoelektronischen Halbleiterchips führt. Es kommt damit im Idealfall zu einem quasi zweidimensionalen Durchbruch über die gesamte Querschnittsfläche des optoelektronischen Halbleiterchips. Damit verursacht ein ESD-Spannungspuls keine Schädigung. Auf diese Weise kann beispielsweise eine ESD-Festigkeit von wenigstens 1 kV erreicht werden.

Erfindungsgemäß weist der pn-Übergang der Mikrodiode eine höhere Einsatzspannung in Durchlassrichtung auf als der pn-Übergang des aktiven Bereichs. Das heißt, dass im ordnungsgemäßen Betrieb des optoelektronischen Halbleiterchips, wenn die pn-Übergänge der Mikrodioden und des aktiven Bereichs also in Durchlassrichtung bestromt werden, der Strom durch den aktiven Bereich fließt, während die Mikrodioden noch sperren. Damit stören die Mikrodioden beispielsweise eine Strahlungserzeugung im aktiven Bereich nicht. Das heißt, die Mikrodioden beeinflussen die Vorwärtscharakteristik des optoelektronischen Halbleiterchips nicht oder kaum. Auch dies kann dadurch erreicht werden, dass zur Bildung der Mikrodioden die oben beschriebenen V-Defekte Verwendung finden.

Gemäß zumindest einer Ausführungsform des optoelektronischen Halbleiterchips beträgt die Dichte der Mikrodioden im optoelektronischen Halbleiterchip wenigstens 5 x 10⁷ pro cm². Beispielsweise beträgt die Dichte der Mikrodioden wenigstens 10⁸ pro cm². Dies kann beispielsweise durch eine entsprechende Wachstumstemperatur erreicht werden, bei der die ESD-Schicht aufgewachsen wird, in der die Mikrodioden angeordnet sind. Die angegebene Dichte bezieht sich dabei auf den Fall der Epitaxie auf ein Saphir-Substrat. Bei geringeren Gitterfehlanpassungen zwischen Wachstumssubstrat und Material der Halbleiterschichtenfolgen sind geringere Dichten möglich und erweisen sich zur Erhöhung der ESD-Festigkeit als sinnvoll.

Gemäß zumindest einer Ausführungsform des optoelektronischen Halbleiterchips sind wenigstens 75 % der Mikrodioden innerhalb einer ESD-Schicht angeordnet. Dabei ist es ausreichend, wenn die p-Seiten oder die n-Seiten der Mikrodioden in der ESD-Schicht angeordnet sind. Es ist möglich, dass alle Mikrodioden in der ESD-Schicht angeordnet sind. Das heißt, alle V-Defekte sind dann in der ESD-Schicht angeordnet.

Die Dicke der ESD-Schicht beträgt bevorzugt wenigstens die Hälfte der Dicke des aktiven Bereichs in der Wachstumsrichtung und bevorzugt maximal das Dreifache der Dicke des aktiven Bereichs in der Wachstumsrichtung. Zum Beispiel weist die ESD-Schicht eine Dicke von wenigstens 80 nm und höchstens 150 nm auf.

Die Dicke der ESD-Schicht gibt dabei auch die Größe der einzelnen Mikrodioden vor, wenn diese als V-Defekte ausgebildet sind. Beispielweise ist die Dicke der ESD-Schicht proportional zur Grundfläche (also zum Beispiel der Grundfläche der hexagonalen Pyramide die den Defekt bildet) eines V-Defekts in der ESD-Schicht. Eine solch große Dicke der ESD-Schicht und die damit verbundene Größe der Mikrodioden stellt eine ausreichende ESD-Festigkeit der Mikrodioden sicher. Beispielsweise sind alle Mikrodioden, das heißt zum Beispiel alle V-Defekte, innerhalb der ESD-Schicht angeordnet.

Gemäß zumindest einer Ausführungsform des optoelektronischen Halbleiterchips fließt ein ESD-Spannungspuls, der in Sperrrichtung an den optoelektronischen Halbleiterchip angelegt wird, in Sperrrichtung der Mikrodioden wenigstens über 50 % der Mikrodioden ab. Das heißt, ein Großteil der Mikrodioden - wenigstens 50 % - haben eine derart ähnliche Durchbruchspannung, dass der ESD-Puls über sie abfließt. Auf diese Weise wird es ermöglicht, dass ein Spannungspuls quasi über die gesamte Querschnittsfläche des optoelektronischen Halbleiterchips abfließen kann, sodass die Stromdichte in den einzelnen Mikrodioden nicht so hoch wird, dass es zu einer Zerstörung des Halbleitermaterials kommen kann. Es ist aber ausreichend, wenn der ESD-Puls über einige wenige Mikrodioden abfließt. Dadurch ist bereits eine gewisse ESD-Festigkeit des Halbeiterchips erreicht.

Gemäß zumindest einer Ausführungsform des optoelektronischen Halbleiterchips sind wenigstens 75 % der Mikrodioden jeweils im Bereich einer Fadenversetzung im Halbleitermaterial des optoelektronischen Halbleiterchips angeordnet. Dies ist beispielsweise dadurch erreicht, dass die Mikrodioden als V-Defekte ausgebildet sind. Die V-Defekte bilden sich bevorzugt an Fadenversetzungen. Über die Dichte der Fadenversetzungen im Halbleitermaterial ist damit auch die Dichte der Mikrodioden einstellbar.

Es wird weiter ein Verfahren zur Herstellung eines optoelektronischen Halbleiterchips angegeben. Vorzugsweise ist mit dem Verfahren ein hier beschriebener optoelektronischer Halbleiterchip herstellbar. Das heißt, die für das Verfahren beschriebenen Merkmale sind auch für den Halbleiterchip offenbart und umgekehrt.

Das Verfahren umfasst beispielsweise die folgenden Schritte:
Zunächst wird ein Wachstumssubstrat bereitgestellt.

In einem nachfolgenden Verfahrensschritt werden eine erste Halbleiterschichtenfolge und eine zweite Halbleiterschichtenfolge, die der ersten Halbleiterschichtenfolge nachfolgt, epitaktisch abgeschieden. Die erste Halbleiterschichtenfolge umfasst eine ESD-Schicht, die bei einer Wachstumstemperatur abgeschieden wird, bei der V-Defekte in hoher Dichte in der ESD-Schicht entstehen.

Üblicherweise versucht man bei der Epitaxie das Auftreten der V-Defekte zu vermeiden. Vorliegend wird jedoch zu Erzeugung der Mikrodioden die ESD-Schicht bei niedrigen Wachstumstemperaturen aufgewachsen, um V-Defekte in ausreichender Dichte zu erzeugen. Der tatsächliche Temperaturbereich, der zur Erzeugung der V-Defekte geeignet ist, hängt dabei von der verwendeten Wachstumsanlage ab. Er kann ermittelt werden, indem eine ESD-Schicht bei unterschiedlichen Temperaturen gewachsen wird, und ein Temperaturbereich ausgewählt wird, bei dem die Dichte der V-Defekte ausreichend oder besonders hoch ist. Erfindungsgemäß wird ein Temperaturbereich von weniger 900°C, insbesondere von wenigstens 790° C und höchstens 870° C gewählt, bei dem die ESD-Schicht abgeschieden wird. Dieser Temperaturbereich hat sich als geeignet zur Bildung von V-Defekten herausgestellt, die in der ESD-Schicht Mikrodioden bilden, über die ein ESD-Spannungspuls abgeführt werden kann. Die zweite Halbleiterschichtenfolge umfasst einen aktiven Bereich. Der aktive Bereich ist vorzugsweise zur Strahlungsdetektion oder Strahlungserzeugung eingerichtet. Die ESD-Schicht wird bei einer Wachstumstemperatur höchstens 900 °C, unter Verwendung eines Tri-Ethyl-Gallium Precursors mit dem Trägergas Stickstoff (N2) aufgewachsen. Dieser Wachstumsmodus hat sich als besonders vorteilhaft zur Erzeugung von V-Defekten mit ähnlichen Abmessungen und damit zur Erzeugung von Mikrodioden mit gleichartigen elektrischen Eigenschaften, insbesondere mit einem gleichartigen Durchbruchsverhalten, herausgestellt. Im Unterschied zu üblichen Wachstumsbedingungen für beispielsweise n-dotierte GaN-Schichten, bei denen die Schichten mit einem Tri-Methyl-Gallium Precursor mit dem Trägergas Wasserstoff (H2) aufgewachsen werden, entstehen unter diesen Wachstumsbedingungen geometrisch sehr ähnliche V-Defekte in großer Dichte. Mit anderen Worten wird das Wachstum in lateraler Richtung, quer zur Wachstumsrichtung beschränkt. Auf diese Weise entstehen V-Defekte insbesondere an Versetzungslinien in einer klar definierten ESD-Schicht.

Gemäß zumindest einer Ausführungsform des Verfahrens weist das Material des Wachstumssubstrats eine Gitterfehlanpassung zum Material der aufzuwachsenden Halbleiterschichtenfolgen aufweist. Beispielsweise wird als Wachstumssubstrat Saphir gewählt und die nachfolgenden Halbleiterschichtenfolgen basieren auf einem Nitrid-Verbindungshalbleitermaterial. In diesem Fall entstehen V-Defekte in besonders großer Dichte. Das Verfahren erweist sich aber sogar in der Homoepitaxie als vorteilhaft, auch wenn die Dichte der V-Defekte in diesem Fall reduziert sein kann.

Die ESD-Schicht basiert auf GaN. Das heißt, die ESD-Schicht kann beispielsweise - bis auf kleine Verunreinigungen oder eine Dotierung - aus GaN bestehen.

Im Folgenden werden der hier beschriebene optoelektronische Halbleiterchip sowie das hier beschriebene Verfahren anhand von Ausführungsbeispielen und den dazugehörigen Figuren näher erläutert.

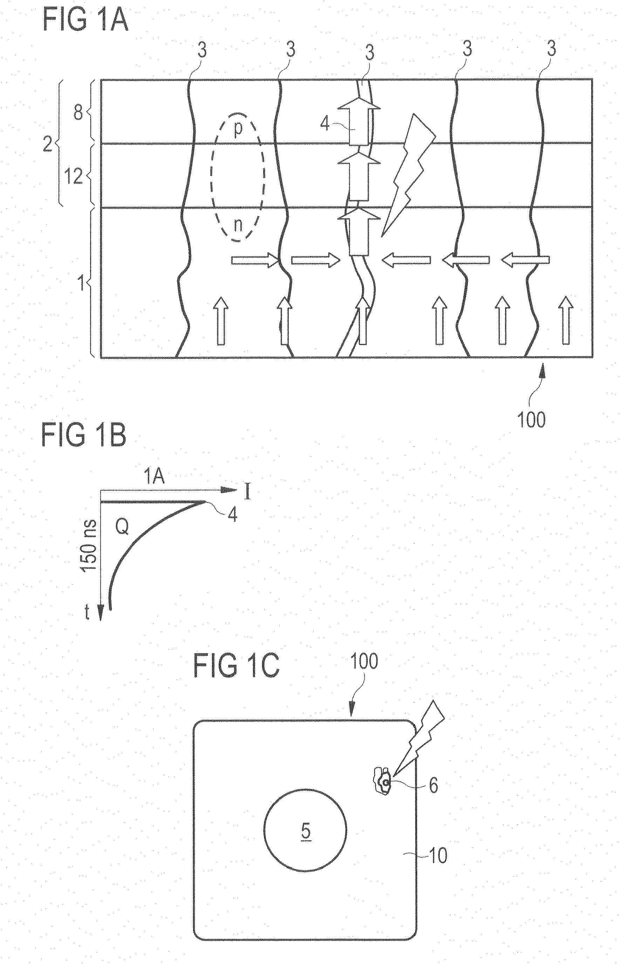

Anhand der Figuren 1A, 1B und 1C ist das dem hier beschriebenen optoelektronischen Halbleiterchip zugrunde liegende Problem näher erläutert.

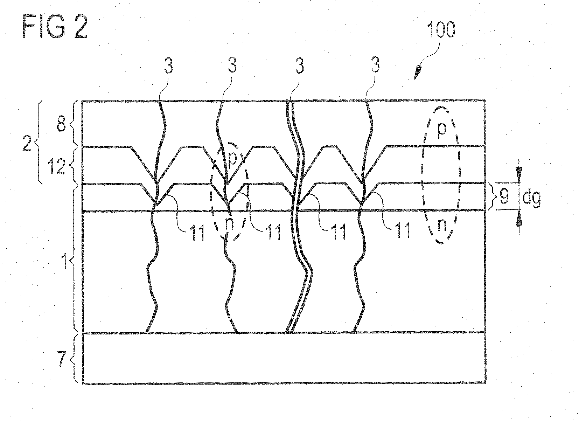

Anhand der Figuren 2, 3A, 3B, 3C, 4A, 4B, 4C, 5, 6 und 7A, 7B, 7C sind Ausführungsbeispiele von hier beschriebenen optoelektronischen Halbleiterchips und von hier beschriebenen Verfahren näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1A zeigt einen herkömmlichen optoelektronischen Halbleiterchip in einer schematischen Schnittdarstellung. Der optoelektronische Halbleiterchip umfasst beispielsweise eine erste Halbleiterschichtenfolge 1 und eine zweite Halbleiterschichtenfolge 2. Bei der ersten Halbleiterschichtenfolge 1 kann es sich um einen n-dotierten Bereich handeln, der beispielsweise auf einem Nitrid-Verbindungshalbleitermaterial basiert. Die zweite Halbleiterschichtenfolge 2 folgt der ersten Halbleiterschichtenfolge 1 in einer Wachstumsrichtung nach und basiert beispielsweise ebenfalls auf einem Nitrid-Verbindungshalbleitermaterial. Die zweite Halbleiterschichtenfolge 2 umfasst einen aktiven Bereich 12. Der aktive Bereich 12 umfasst beispielsweise zumindest eine Mehrfachquantentopfstruktur, die im Betrieb des optoelektronischen Halbleiterchips zur Erzeugung von elektromagnetischer Strahlung vorgesehen ist. Ferner kann die zweite Halbleiterschichtenfolge 2 einen p-dotierten Bereich 8 umfassen. Am aktiven Bereich 12 ist damit ein pn-Übergang ausgebildet.

Der optoelektronische Halbleiterchip 100 ist von Versetzungen, beispielsweise so genannten Fadenversetzungen 3 durchzogen. Diese treten insbesondere bei der Heteroepitaxie des Nitrid-Verbindungshalbleitermaterials auf Saphir in hoher Dichte auf. Die Fadenversetzungen 3 stellen dabei potentielle Pfade für einen ESD-Spannungspuls 4 dar, dessen elektrische Ladung in Sperrrichtung des pn-Übergangs abgeleitet wird. Problematisch ist dabei, dass die Ladung durch den schwächsten oder wenige schwache Leckpfade abfließt, die sich entlang einer oder weniger der Fadenversetzungen 3 ausbilden.

Die Figur 1B zeigt dabei die Strom (I)-Zeit (t)-Kennlinie eines üblichen ESD-Spannungspulses 4.

Durch das Abfließen der Ladung eines ESD-Spannungspulses 4 durch eine oder wenige Fadenversetzungen 3 kommt es zu einer Zerstörung 6 des optoelektronischen Halbleiterchips 100, wie sie in der Figur 1C dargestellt ist.

Die Figur 1C zeigt dabei eine Draufsicht auf die Strahlungsdurchtrittsfläche 10 eines optoelektronischen Halbleiterchips 100, wobei auf der Strahlungsdurchtrittsfläche 10 ein elektrischer Kontakt 5 angeordnet ist.

Dem hier beschriebenen optoelektronischen Halbleiterchip liegt nun unter anderem die Idee zugrunde, die durch die Fadenversetzungen 3 gebildeten Leckstrompfade über Mikrodioden 11 in einer eigens dafür eingefügten ESD-Schicht 9 zu kapseln. Grundlage für die Mikrodioden 11 sind die V-Defekte, die über bestimmte Wachstumsbedingungen erzeugt werden und vorzugsweise genau an den Linien der Fadenversetzungen 3 entstehen. Das heißt, an den potentiellen Strompfaden werden gezielt V-Defekte erzeugt, welche Mikrodioden 11 bilden. Vorzugsweise umfassen wenigstens 75 %, besonders bevorzugt alle Fadenversetzungen 3 eine Mikrodiode 11. Dies ist in einer schematischen Schnittdarstellung des optoelektronischen Halbleiterchips 100 in der Figur 2 dargestellt.

Die V-Defekte, welche Mikrodioden 11 bilden, weisen bevorzugt ähnliche Abmessungen auf. Das heißt, ein Großteil der V-Defekte weist beispielsweise an der Schnittstelle zwischen der ESD-Schicht 9 und der aktiven Schicht 12 eine ähnliche Grundfläche auf. Eine ähnliche Grundfläche ist beispielsweise dadurch gekennzeichnet, dass sie innerhalb eines Bereichs von ±25 %, insbesondere von ±10 % um einen Mittelwert der Grundflächen aller V-Defekte an der Grenzfläche liegt. Die V-Defekte mit ähnlichen Abmessungen bilden Mikrodioden 11, die gleichartige elektrische Eigenschaften, insbesondere ein gleichartiges Durchbruchverhalten aufweisen.

Der optoelektronische Halbleiterchip 100 umfasst ein Substrat 7, das beispielsweise Saphir enthält oder aus Saphir besteht. Auf das Substrat 7 sind nachfolgend die erste Halbleiterschichtenfolge 1 und die zweite Halbleiterschichtenfolge 2 abgeschieden.

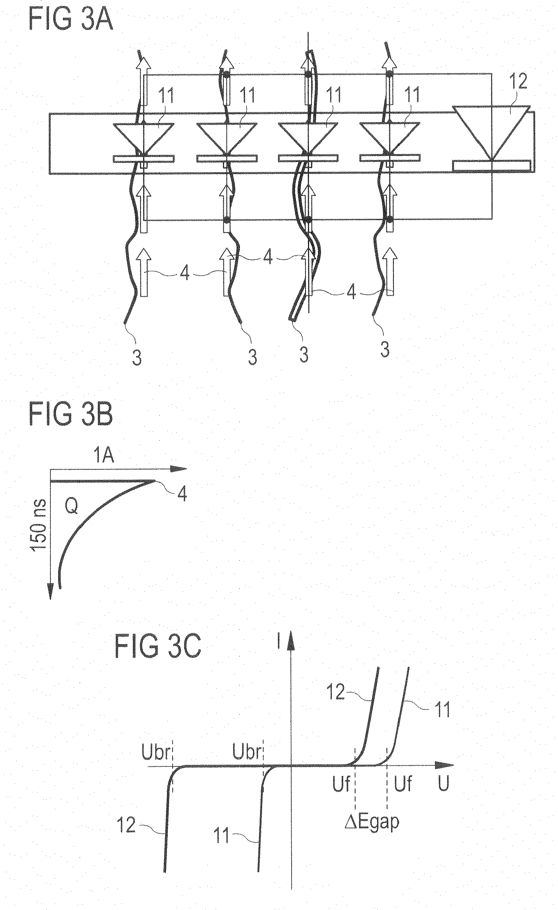

Im Unterschied zum in Verbindung mit der Figur 1A beschriebenen optoelektronischen Halbleiterchip 100 umfasst die erste Halbleiterschichtenfolge 1 nun die ESD-Schicht 9, welche V-Defekte enthält, die die Mikrodioden 11 bilden. Die Figur 3A zeigt eine schematische Schaltskizze für den optoelektronischen Halbleiterchip 100 der Figur 2.

Die Mikrodioden 11 weisen ein gleichartiges Durchbruchsverhalten auf, das heißt, sie weisen die gleiche oder im Wesentlichen die gleiche Durchbruchspannung auf. Die Durchbruchspannung der Mikrodioden 11 ist dabei kleiner als die Durchbruchspannung des pn-Übergangs, der durch den aktiven Bereich gebildet ist. Die Mikrodioden 11 öffnen daher bei einem ESD-Spannungspuls 4 (vergleiche die Figur 3B) in Sperrrichtung gleichzeitig. Damit fließt die durch den ESD-Spannungspuls 4 eingeprägte Ladung nicht über den oder die schwächsten Leckpfade entlang der Versetzungslinien 3, wie es in der Figur 1A gezeigt ist, sondern die Ladung verteilt sich auf das Ensemble der Mikrodioden 11. Damit wird an keinem der Pfade eine kritische Stromdichte erreicht, die zur Zerstörung 6 des optoelektronischen Halbleiterchips 100 führt. Es findet ein quasi-zweidimensionaler Durchbruch über die gesamte Querschnittsfläche des optoelektronischen Halbleiterchips 100 statt, sodass eine ESD-Festigkeit von wenigstens 1 kV, beispielsweise von typisch 2 kV erreicht wird. Das heißt, über die Mikrodioden werden die schwächsten Leckstrompfade im optoelektronischen Halbleiterchip geschützt und die Belastung durch einen ESD-Spannungspuls wird auf alle Mikrodioden 11 oder zumindest einen Großteil der Mikrodioden 11, verteilt, sodass die auftretenden Stromdichten jeweils so klein sind, dass keine Schädigung eintritt.

Die Figur 3C zeigt dabei schematisch die Strom (I)-Spannung (U) -Kennlinien der Mikrodioden 11 und des aktiven Bereichs 12. Die Durchbruchspannung UBR der Mikrodioden 11 ist kleiner als die Durchbruchspannung des aktiven Bereichs 12. Die Einsatzspannung UF des aktiven Bereichs 12 ist dahingehend kleiner als die Einsatzspannung der Mikrodioden 11, sodass die Vorwärtscharakteristik des optoelektronischen Halbleiterchips 100 durch die Mikrodioden 11 kaum oder gar nicht gestört wird.

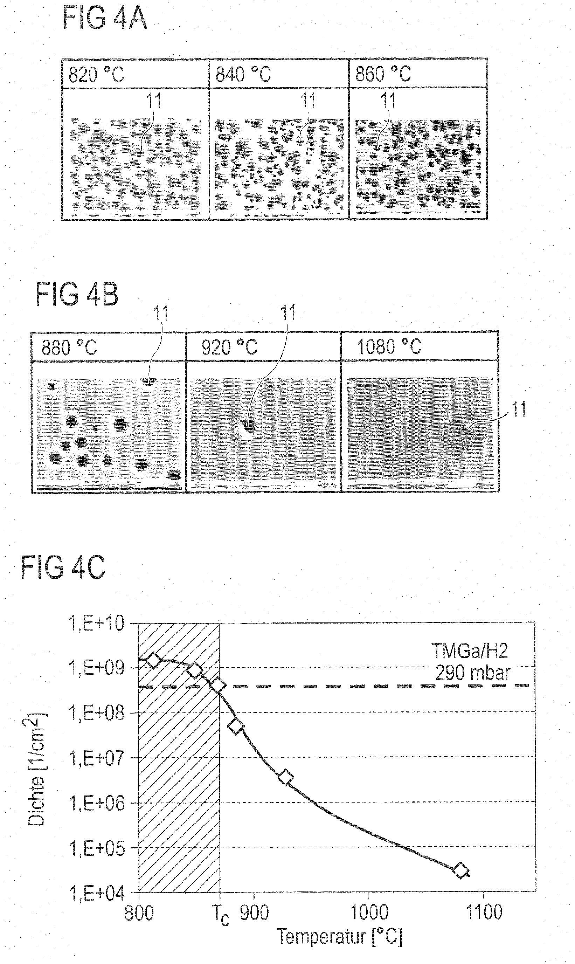

In Verbindung mit den Figuren 4A bis 4C sind die Wachstumsbedingungen näher beschrieben, unter denen die ESD-Schicht 9 mit den Mikrodioden 11 erzeugt werden kann. Die Figur 4A zeigt Aufnahmen des optoelektronischen Halbleiterchips, wobei die ESD-Schichten 9 bei unterschiedlichen Temperaturen zwischen 820° C und 860° C gewachsen sind. Die Figur 4B zeigt Aufnahmen von ESD-Schichten 9, die bei Temperaturen zwischen 880° C und 1080° C gewachsen sind.

Die Figur 4C zeigt eine grafische Auftragung der Dichte der V-Defekte in Abhängigkeit von der Wachstumstemperatur. Wie den Figuren 4A bis 4C zu entnehmen ist, hängt die Dichte der V-Defekte stark von der Wachstumstemperatur T ab. Die ESD-Schicht 9 besteht dabei beispielsweise aus Galliumnitrid. Eine ausreichende Dichte an V-Defekten und damit an Mikrodioden 11 zum Schutz des optoelektronischen Halbleiterchips 100 wird vorliegend unterhalb der kritischen Temperatur TC von circa 870° C erreicht. Diese Temperatur kann von der verwendeten Wachstumsanlage und / oder dem Ort der Temperaturmessung in der Anlage abhängen. Die kritische Temperatur, unterhalb der die Dichte der V-Defekte ausreichend groß ist, kann jedoch wie in den Figur 4A bis 4C gezeigt ist, ermittelt werden.

Während die Dichte der Mikrodioden 11 also über die Wachstumstemperatur T eingestellt werden kann, ist auch die Größe der V-Defekte wichtig, um eine ausreichende ESD-Festigkeit des optoelektronischen Halbleiterchips 100 zu erreichen.

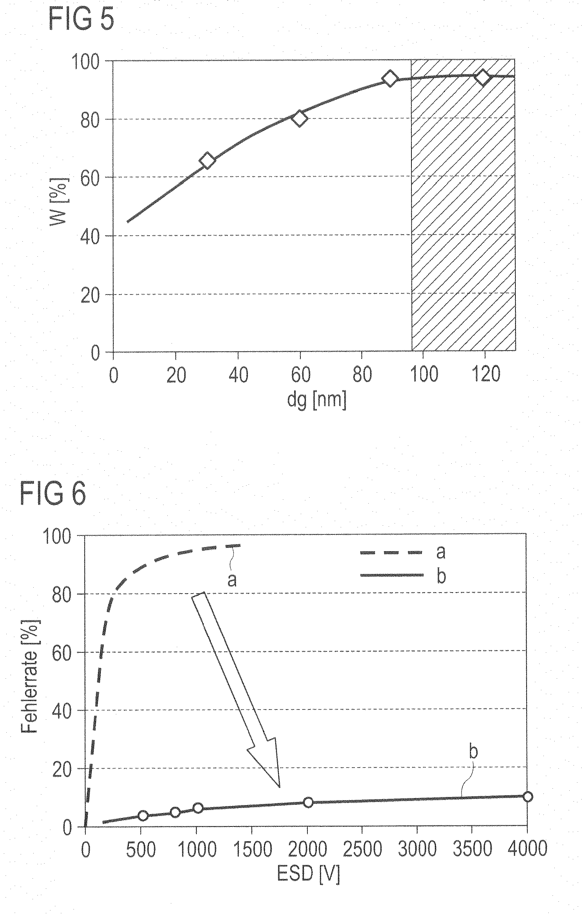

Die grafische Auftragung der Figur 5 zeigt dabei die Dicke D9 der ESD-Schicht 9 (vergleiche dazu auch die Figur 2) aufgetragen gegen die Wahrscheinlichkeit W, dass ein optoelektronischer Halbleiterchip 10 einem wie beispielsweise in der Figur 3B gezeigten ESD-Spannungspuls 4 unbeschadet übersteht. Wie der Figur 5 zu entnehmen ist, erweist sich vorliegend eine Dicke der ESD-Schicht 9 von wenigstens 80 nm, vorzugsweise von wenigstens 100 nm, als besonders geeignet. Die geeignete Dicke hängt dabei wie oben beschrieben von der Dicke des aktiven Bereichs ab.

Die grafische Auftragung der Figur 6 zeigt die Fehlerrate der optoelektronischen Halbleiterchips 100 für herkömmliche, Halbleiterchips a und hier beschriebene optoelektronische Halbleiterchips b aufgetragen gegen die ESD-Spannung in Volt.

Wie der Figur 6 zu entnehmen ist, sinkt die Fehlerrate im Fall von ESD-Spannungspulsen 4 stark ab.

Dabei hat sich gezeigt, dass der ESD-Schutz insbesondere für grünes Licht emittierende Leuchtdiodenchips oder grünes Licht emittierende Laserdiodenchips besonders vorteilhaft ist, da diese - aufgrund des hohen Indiumgehalts in der aktiven Zone - ohne die Mikrodioden 11 besonders ESD-anfällig sind.

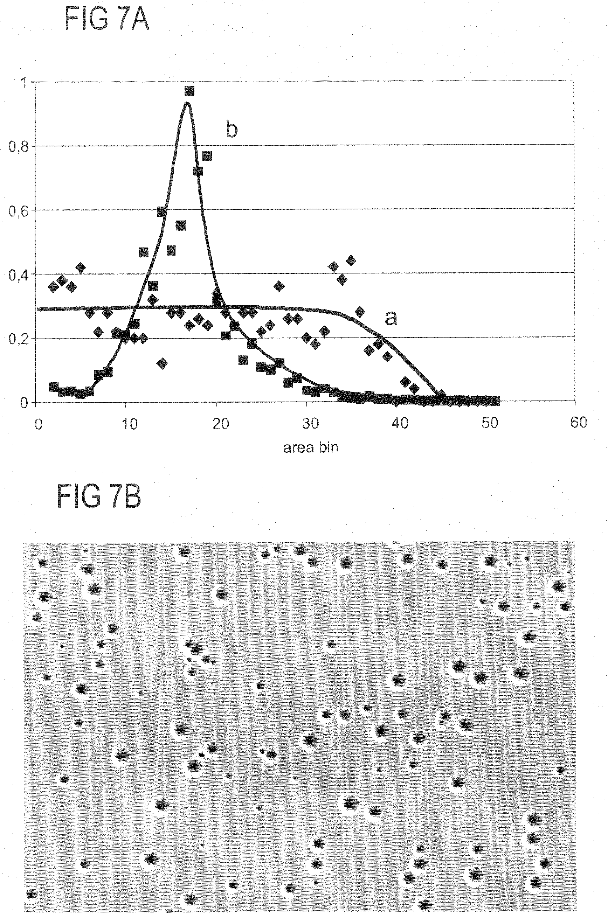

Die Figur 7A zeigt eine grafische Auftragung der Grundflächen von V-Defekten für einen ersten Wachstumsmodus (Kurve a) und einen zweiten Wachstumsmodus (Kurve b). Die Grundflächen sind dabei in sogenannte "area bins" (also Klassen gleicher oder ähnlicher Grundfläche) einsortiert, die Anzahl der jeweiligen V-Defekte in der zugeordneten Klasse ist relativ zur Gesamtanzahl angegeben. Wie aus der Figur 7A ersichtlich ist, weist die Kurve a für den ersten Wachstumsmodus eine starke Verteilung der Abmessungen der V-Defekte auf. Diese V-Defekte wurden mit einem Tri-Methyl-Gallium Precursor mit dem Trägergas Wasserstoff aufgewachsen. Die Figur 7B zeigt eine entsprechende Aufnahme der Grundflächen von V-Defekten in einer Ebene senkrecht zur Wachstumsrichtung.

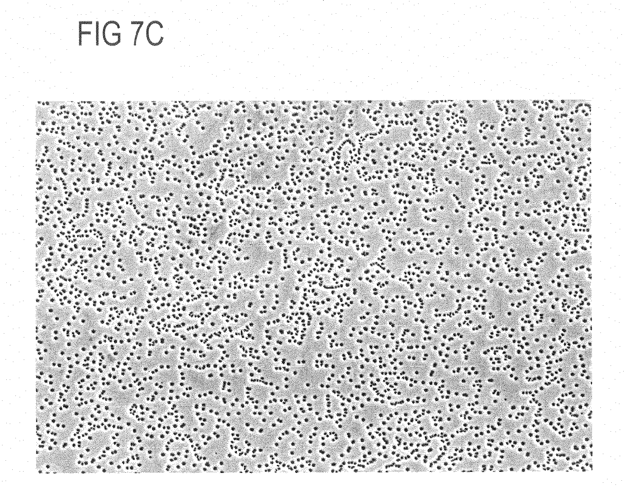

Dahingegen weist die Kurve b ein ausgeprägtes Maximum auf, das heißt ein Großteil der V-Defekte weist eine ähnliche oder gleiche Grundfläche auf. Diese V-Defekte wurden mit einem Tri-Ethyl-Gallium Precursor mit dem Trägergas Stickstoff bei einer Wachstumstemperatur von kleiner 900 °C aufgewachsen. Die Figur 7C zeigt eine entsprechende Aufnahme der V-Defekte in einer Ebene senkrecht zur Wachstumsrichtung. Diese V-Defekte bilden Mikrodioden mit gleichartigen elektrischen Eigenschaften, die sich besonders gut zum ESD-Schutz des optoelektronischen Halbleiterchips eignen.

Die Erfindung ist nicht durch die Beschreibung anhand der Ausführungsbeispiele auf diese beschränkt, sondern wird durch die nachfolgenden Ansprüche definiert.

Diese Patentanmeldung beansprucht die Priorität der deutschen Patentanmeldung 102009060750. 1.

Diese Patentanmeldung ist eine Teilanmeldung zur europäischen Anmeldung EP 10796415. 7-1551.

## Patentansprüche

1. Verfahren zur Herstellung eines optoelektronischen Halbleiterchips (100) mit den Schritten:
- Bereitstellen eines Wachstumssubstrats (7),
- epitaktisches Abscheiden einer ersten Halbleiterschichtenfolge (1),
- epitaktisches Abscheiden einer zweiten Halbleiterschichtenfolge (2) auf die erste Halbleiterschichtenfolge (1), wobei
- die erste Halbleiterschichtenfolge (1) eine ESD-Schicht (9) umfasst, die bei einer Wachstumstemperatur abgeschieden wird, bei der V-Defekte in hoher Dichte in der ESD-Schicht (9) auftreten, und
- die zweite Halbleiterschichtenfolge (2) einen aktiven Bereich (12) umfasst, **dadurch gekennzeichnet, dass**
- die ESD-Schicht (9) auf GaN basiert, wobei die ESD-Schicht bei einer Wachstumstemperatur kleiner 900°C unter Verwendung eines Tri-Ethyl-Gallium Precursors mit dem Trägergas Stickstoff aufgewachsen wird.

2. Verfahren nach dem vorherigen Anspruch, wobei das Wachstumssubstrat Saphir umfasst oder aus Saphir besteht.

3. Verfahren nach einem der vorherigen Ansprüche, wobei die ESD-Schicht (9) bis auf kleine Verunreinigungen oder eine Dotierung aus GaN besteht.

4. Verfahren nach einem der vorherigen Ansprüche, wobei die V-Defekte Mikrodioden (11) bilden, wobei ein Großteil der V-Defekte ähnliche Abmessungen aufweist.

5. Verfahren nach Anspruch 4, wobei
- zumindest eine der Mikrodioden (11) einen pn-Übergang umfasst,
- der aktive Bereich (12) zumindest einen pn-Übergang umfasst, wobei
- der pn-Übergang der Mikrodiode (11) und der pn-Übergang des aktiven Bereichs (12) gleichgerichtet sind, und
- der pn-Übergang der Mikrodiode (11) eine niedrigere Durchbruchsspannung (UBR) in Sperrrichtung aufweist als der pn-Übergang des aktiven Bereichs (12).

6. Verfahren nach Anspruch 4 oder 5, bei dem
- zumindest eine der Mikrodioden (11) einen pn-Übergang umfasst,
- der aktive Bereich (12) zumindest einen pn-Übergang umfasst, wobei
- der pn-Übergang der Mikrodiode (11) und der pn-Übergang des aktiven Bereichs (12) gleichgerichtet sind, und
- der pn-Übergang der Mikrodiode (11) eine höhere Einsatzspannung (UF) in Durchlassrichtung aufweist als der pn-Übergang des aktiven Bereichs (12).

7. Optoelektronischer Halbleiterchip (100) mit
- einer ersten Halbleiterschichtenfolge (1), die eine Vielzahl von Mikrodioden (11) umfasst, und
- einer zweiten Halbleiterschichtenfolge (2), die einen aktiven Bereich (12) umfasst, wobei
- die Mikrodioden (11) jeweils einen pn-Übergang umfassen,
- der aktive Bereich (12) zumindest einen pn-Übergang umfasst,
- die erste Halbleiterschichtenfolge (1) und die zweite Halbleiterschichtenfolge (2) auf einem Nitrid-Verbindungshalbleitermaterial basieren,
- die erste Halbleiterschichtenfolge (1) der zweiten Halbleiterschichtenfolge (2) in Wachstumsrichtung vorgelagert ist, und
- die Mikrodioden (11) einen ESD-Schutz für den aktiven Bereich (12) bilden, **dadurch gekennzeichnet, dass**
- wenigstens 50 % der Mikrodioden (11) ein gleichartiges Durchbruchverhalten aufweisen, wobei eine Durchbruchspannung von wenigstens 50 % der Mikrodioden in einem Bereich von ± 25 % um einen Mittelwert der Durchbruchspannung der Mikrodioden ist,
- die pn-Übergänge der Mikrodioden (11) und der pn-Übergang des aktiven Bereichs (12) gleichgerichtet sind, und
- die pn-Übergänge der Mikrodioden (11) eine höhere Einsatzspannung (UF) in Durchlassrichtung aufweist als der pn-Übergang des aktiven Bereichs (12).

8. Optoelektronischer Halbleiterchip (100) nach dem vorherigen Anspruch, bei dem
- die Mikrodioden (11) jeweils durch V-Defekte gebildet sind, wobei wenigsten 50 % der V-Defekte ähnliche Abmessungen aufweisen, wobei eine Grundfläche der V-Defekte in einer Ebene senkrecht zur Wachstumsrichtung höchstens um ± 25 % um einen Mittelwert der Grundfläche der V-Defekte in dieser Ebene schwankt.

9. Optoelektronischer Halbleiterchip (100) nach einem der vorherigen Ansprüche, bei dem
die pn-Übergänge der Mikrodioden (11) eine niedrigere Durchbruchsspannung (UBR) in Sperrrichtung aufweisen als der pn-Übergang des aktiven Bereichs (12).

10. Optoelektronischer Halbleiterchip (100) nach einem der vorherigen Ansprüche, bei dem
die Dichte der Mikrodioden (11) wenigstens 5*10^7/cm^2 beträgt.

11. Optoelektronischer Halbleiterchip (100) nach einem der vorherigen Ansprüche, bei dem
wenigstens 75% der Mikrodioden (11) innerhalb einer ESD-Schicht (9) angeordnet sind, die eine Dicke (d9) von wenigstens der Hälfte und höchstens des Dreifachen der Dicke des aktiven Bereichs (11) aufweist.

12. Optoelektronischer Halbleiterchip (100) nach einem der vorherigen Ansprüche, bei dem
ein ESD-Spannungspuls (4) in Sperrrichtung der Mikrodioden (11) wenigstens über 50% der Mikrodioden (11) abfließt.

13. Optoelektronischer Halbleiterchip (100) nach einem der vorherigen Ansprüche, bei dem
wenigstens 75% der Mikrodioden (11) jeweils im Bereich einer Fadenversetzung (3) angeordnet sind.

14. Optoelektronischer Halbleiterchip (100) nach einem der vorherigen Ansprüche, bei dem
die zweite Halbleiterschichtenfolge (2) der ersten Halbleiterschichtenfolge (1) direkt nachfolgt.

15. Optoelektronischer Halbleiterchip (100) nach einem der vorherigen Ansprüche,
der im Betrieb blaues und/oder grünes Licht emittiert.

## Claims

1. Method for producing an optoelectronic semiconductor chip (100) with the steps of:
- providing a growth substrate (7),
- epitaxial depositing a first semiconductor layer sequence (1),
- epitaxial depositing a second semiconductor layer sequence (2) on the first semiconductor layer sequence (1), wherein
- the first semiconductor layer sequence (1) comprises an ESD layer (9) deposited at a growth temperature at which V defects occur in high density in the ESD layer (9), and
- the second semiconductor layer sequence (2) comprises an active region (12), **characterized in that**
- the ESD layer (9) is based on GaN, wherein the ESD layer is grown at a growth temperature lower than 900°C using a tri-ethyl gallium precursor with the carrier gas nitrogen.

2. Method according to the preceding claim, wherein
the growth substrate comprises sapphire or consists of sapphire.

3. Method according to any one of the preceding claims, wherein
the ESD layer (9) consists of GaN except for small impurities or a doping.

4. Method according to any one of the preceding claims, wherein
the V-defects form microdiodes (11), with a majority of the V-defects having similar dimensions.

5. Method according to claim 4, wherein
- at least one of the microdiodes (11) comprises a pn junction,
- the active region (12) comprises at least one pn junction, wherein
- the pn junction of the microdiode (11) and the pn junction of the active region (12) are rectified, and
- the pn junction of the microdiode (11) has a lower breakdown voltage (UBR) in the reverse direction than the pn junction of the active region (12).

6. Method according to claim 4 or 5, wherein
- at least one of the microdiodes (11) comprises a pn junction,
- the active region (12) comprises at least one pn junction, wherein
- the pn junction of the microdiode (11) and the pn junction of the active region (12) are rectified, and
- the pn junction of the microdiode (11) has a higher forward bias voltage (UF) than the pn junction of the active region (12) .

7. Optoelectronic semiconductor chip (100) with
- a first semiconductor layer sequence (1) comprising a plurality of microdiodes (11), and
- a second semiconductor layer sequence (2) comprising an active region (12), wherein
- the microdiodes (11) each comprise a pn junction,
- the active region (12) comprises at least one pn junction,
- the first semiconductor layer sequence (1) and the second semiconductor layer sequence (2) are based on a nitride compound semiconductor material,
- the first semiconductor layer sequence (1) is upstream the second semiconductor layer sequence (2) in the growth direction, and
- the microdiodes (11) form an ESD protection for the active area (12), **characterized in that**
- at least 50% of the microdiodes (11) have a similar breakdown behaviour, wherein a breakdown voltage of at least 50% of the microdiodes is in a range of ± 25% around an average value of the breakdown voltage of the microdiodes,
- the pn junctions of the microdiodes (11) and the pn junction of the active region (12) are rectified, and
- the pn junctions of the microdiodes (11) have a higher forward bias voltage (UF) than the pn junction of the active region (12).

8. Optoelectronic semiconductor chip (100) according to the preceding claim, in which
- the microdiodes (11) are each formed by V-defects, at least 50% of the V-defects having similar dimensions, wherein a base area of the V-defects in a plane perpendicular to the growth direction varies by at most ± 25% around a mean value of the base area of the V-defects in that plane.

9. Optoelectronic semiconductor chip (100) according to any one of the preceding claims, in which
the pn junctions of the microdiodes (11) have a lower breakdown voltage (UBR) in the reverse direction than the pn junction of the active region (12).

10. Optoelectronic semiconductor chip (100) according to any one of the preceding claims, in which
the density of the microdiodes (11) is at least 5*10^7/cm^2.

11. Optoelectronic semiconductor chip (100) according to any one of the preceding claims, in which
at least 75% of the microdiodes (11) are arranged within an ESD layer (9) having a thickness (d9) of at least half and at most three times the thickness of the active region (11).

12. Optoelectronic semiconductor chip (100) according to any one of the preceding claims, in which
an ESD voltage pulse (4) flows off in the reverse direction of the microdiodes (11) over at least 50% of the microdiodes (11) .

13. Optoelectronic semiconductor chip (100) according to any one of the preceding claims, in which
at least 75% of the microdiodes (11) are each arranged in the region of a threading dislocation (3).

14. Optoelectronic semiconductor chip (100) according to any one of the preceding claims, in which
the second semiconductor layer sequence (2) directly follows the first semiconductor layer sequence (1).

15. Optoelectronic semiconductor chip (100) according to any one of the preceding claims,
which emits blue and/or green light during operation.

## Revendications

1. Procédé de fabrication d'une puce semi-conductrice optoélectronique (100) comprenant les étapes consistant à:
- fournir un substrat de croissance (7),
- dépôt épitaxial d'une première séquence de couches semi-conductrices (1),
- dépôt épitaxial d'une deuxième séquence de couches semi-conductrices (2) sur la première séquence de couches semi-conductrices (1), dans lequel
- la première séquence de couches semi-conductrices (1) comprend une couche ESD (9) qui est déposée à une température de croissance à laquelle des défauts V apparaissent à haute densité dans la couche ESD (9), et
- la deuxième séquence de couches semi-conductrices (2) comprend une zone active (12), **caractérisée en ce que**
- la couche ESD (9) est à base de GaN, la couche ESD étant développée à une température de croissance inférieure à 900°C en utilisant un précurseur de tri-éthyle-gallium avec le gaz porteur azote.

2. Procédé selon la revendication précédente, dans lequel le substrat de croissance comprend du saphir ou est constitué de saphir.

3. Procédé selon l'une quelconque des revendications précédentes, dans lequel
la couche ESD (9) est constituée de GaN, à l'exception de petites impuretés ou d'un dopage.

4. Procédé selon l'une quelconque des revendications précédentes, dans lequel
les défauts en V forment des microdiodes (11), une grande partie des défauts en V ayant des dimensions similaires.

5. Procédé selon la revendication 4, dans lequel
- au moins une des microdiodes (11) comprend une jonction pn,
- la région active (12) comprend au moins une jonction pn, dans laquelle
- la jonction pn de la microdiode (11) et la jonction pn de la région active (12) sont redressées, et
- la jonction pn de la microdiode (11) présente une tension de claquage (UBR) plus faible dans le sens inverse que la jonction pn de la zone active (12).

6. Procédé selon la revendication 4 ou 5, dans lequel
- au moins une des microdiodes (11) comprend une jonction pn,
- la région active (12) comprend au moins une jonction pn, dans laquelle
- la jonction pn de la microdiode (11) et la jonction pn de la région active (12) sont redressées, et
- la jonction pn de la microdiode (11) présente une tension d'insertion (UF) plus élevée dans la direction de conduction que la jonction pn de la région active (12).

7. Puce semi-conductrice optoélectronique (100) comprenant
- une première séquence de couches semi-conductrices (1) comprenant une pluralité de microdiodes (11), et
- une deuxième séquence de couches semi-conductrices (2) comprenant une région active (12), dans laquelle
- les microdiodes (11) comprennent chacune une jonction pn,
- la région active (12) comprend au moins une jonction pn,
- la première séquence de couches semi-conductrices (1) et la deuxième séquence de couches semi-conductrices (2) sont basées sur un matériau semi-conducteur composé de nitrure,
- la première séquence de couches semi-conductrices (1) est située en amont de la deuxième séquence de couches semi-conductrices (2) dans la direction de croissance, et
- les microdiodes (11) forment une protection ESD pour la zone active (12), **caractérisée en ce que**
- au moins 50 % des microdiodes (11) ont un comportement de claquage similaire, dans lequel une tension de claquage d'au moins 50 % des microdiodes est dans une plage de ± 25 % autour d'une valeur moyenne de la tension de claquage des microdiodes,
- les jonctions pn des microdiodes (11) et la jonction pn de la région active (12) sont redressées, et
- les jonctions pn des microdiodes (11) présentent une tension d'insertion (UF) plus élevée dans la direction de conduction que la jonction pn de la région active (12).

8. Puce semi-conductrice optoélectronique (100) selon la revendication précédente, dans laquelle
- les microdiodes (11) sont formées chacune par des défauts en V, au moins 50 % des défauts en V présentant des dimensions similaires, une surface de base des défauts en V dans un plan perpendiculaire à la direction de croissance variant au maximum de ± 25 % autour d'une valeur moyenne de la surface de base des défauts en V dans ce plan.

9. Puce semi-conductrice optoélectronique (100) selon l'une quelconque des revendications précédentes, dans laquelle
les jonctions pn des microdiodes (11) présentent une tension de claquage (UBR) plus faible dans la direction de blocage que la jonction pn de la région active (12).

10. Puce semi-conductrice optoélectronique (100) selon l'une quelconque des revendications précédentes, dans laquelle
la densité des microdiodes (11) est d'au moins 5*10^7/cm^2.

11. Puce semi-conductrice optoélectronique (100) selon l'une quelconque des revendications précédentes, dans laquelle
au moins 75% des microdiodes (11) sont disposées à l'intérieur d'une couche ESD (9) ayant une épaisseur (d9) d'au moins la moitié et d'au plus trois fois l'épaisseur de la région active (11).

12. Puce semi-conductrice optoélectronique (100) selon l'une quelconque des revendications précédentes, dans laquelle
une impulsion de tension ESD (4) s'écoule dans la direction de blocage des microdiodes (11) au moins sur 50% des microdiodes (11).

13. Puce semi-conductrice optoélectronique (100) selon l'une quelconque des revendications précédentes, dans laquelle
au moins 75% des microdiodes (11) sont respectivement disposées dans la zone d'un décalage de fil (3).

14. Puce semi-conductrice optoélectronique (100) selon l'une quelconque des revendications précédentes, dans laquelle
la deuxième séquence de couches semi-conductrices (2) suit directement la première séquence de couches semi-conductrices (1) .

15. Puce semi-conductrice optoélectronique (100) selon l'une quelconque des revendications précédentes,
qui, en fonctionnement, émet une lumière bleue et/ou verte.
